# EUROPEAN PATENT SPECIFICATION

(11) **EP 3 522 347 B1**
(45) Date of publication and mention of the grant of the patent: **15.12.2021**
(21) Application number: 17855608.0
(22) Date of filing: 05.09.2017
(51) Int. Cl.: H02M 1/00, H03K 17/18

(54) **ELECTRIC POWER CONVERTING DEVICE AND METHOD OF RECORDING STATE THEREOF**
VORRICHTUNG ZUR UMWANDLUNG VON ELEKTRISCHEM STROM UND VERFAHREN ZUR AUFZEICHNUNG DES ZUSTANDS DAVON
DISPOSITIF DE CONVERSION D'ÉNERGIE ÉLECTRIQUE ET PROCÉDÉ D'ENREGISTREMENT DE SON ÉTAT

(30) Priority: 29.09.2016 JP 2016190512
(43) Date of publication of application: 07.08.2019
(73) Proprietor: Hitachi, Ltd., Tokyo 100-8280 (JP)
(72) Inventor: MAE, Kentarou, Tokyo 100-8280 (JP); ISHIKAWA, Katsumi, Tokyo 100-8280 (JP)
(74) Representative: Mewburn Ellis LLP
(86) International application number: PCT/JP2017/031912
(87) International publication number: WO 2018/061650

(56) References cited:
- JP-A- 2002 368 593
- JP-A- 2005 033 997
- JP-A- 2007 082 360
- JP-A- 2011 015 597
- JP-A- 2011 072 187
- JP-A- 2012 060 793
- JP-A- 2015 139 271
- JP-A- 2016 163 512
- US-A1- 2003 052 401

## Description

### Technical Field

The present invention relates to an electric power converting device equipped with a semiconductor element.

### Background Art

In an electric power converting device equipped with a semiconductor element, it sometimes happen that a large current exceeding rated current flows in the semiconductor element or a high voltage exceeding rated voltage is applied to it. Electric power converting devices include those provided with a protection function for protecting the semiconductor element from such an overcurrent or an overvoltage.

An overcurrent is often arisen by a short circuit state occurring within a circuit. What causes a short circuit state includes breakdown of a semiconductor element comprised in a circuit, malfunction of a drive circuit, and incorrect wiring among others. Meanwhile, a semiconductor element has a behavior that limits current to below a certain current value for a period after occurrence of a short circuit state, even if it occurs. This behavior is called a short circuit withstanding capacity and it is possible to pre-empt breakdown of a semiconductor element if current can be cut off immediately after occurrence of a short circuit state, even if it occurs. A function of thus pre-empting a short-circuit breakdown of a semiconductor element is called a short-circuit protection function.

On the other hand, an overvoltage is often arises by a surge voltage when a semiconductor element is switched over. Amplitude of a surge voltage correlates with how much parasitic inductance is in a circuit including the semiconductor element and what current change rate is when the semiconductor device is switched over. Now, to reduce the surge voltage, it is effective to use a structure in which parasitic inductance is minimized, use a structure in which a snubber circuit is incorporated, or use a driver circuit structure making a gradual change of current. It is anticipated that, for instance, malfunction of a driver circuit due to noise makes a steep change of current when the semiconductor device is switched over, resulting in an overvoltage. When an overvoltage occurs, it is needed to restrain rise of voltage before a voltage that breaks down the semiconductor device is reached. What provides a function of restricting voltage to below a certain voltage value is, inter alia, a clamp circuit.

In order to activate a protection function for protecting a semiconductor element from overcurrent or overvoltage, it is required to detect a state of the semiconductor element to be protected, acquire a signal, and determine whether abnormality is present or not. In Patent Literature 1, disclosed is a technical approach that adjusts the amount of current flowing into a gate, based on signals regarding a main terminal current and a gate voltage, to restrain an overcurrent due to a short circuit, thus protecting a semiconductor element.

### Citation List

### Patent Literature

Patent Literature 1: Japanese Unexamined Patent Application Publication No. 2015-139271

JP 2007 082360 A describes a drive control unit for electric motor being composed of a main circuit section, which converts a DC power supply into AC and drives an electric motor as a load, a driver circuit section for driving a power semiconductor switching element of the main circuit section and the host controller for transmitting a drive signal to a driver circuit section.

US 2003/052401 A1 describes a semiconductor power module capable of efficiently utilizing the performance of the module and facilitating management of the module in custody. The semiconductor power module having one or more semiconductor power switching elements and a drive unit is provided with a non-volatile memory for storing use history of the module and a drive unit. The use history contains information of one of the number of switching times of the semiconductor power switching element, the number of over-current detections of the semiconductor power switching element and a temperature rise of the semiconductor power module.

JP 2016 163512 A describes an intelligent power module 1 including a chip temperature detection circuit for detecting a chip temperature as the temperature of an IGBT chip 10, a case temperature detection circuit for detecting a case temperature as the temperature of a case enclosing the intelligent power module and a memory circuit for recording the chip temperature detected by the chip temperature detection circuit and the case temperature detected by the case temperature detection circuit.

### Summary of Invention

### Technical Problem

The present inventors concentrated on examinations on extracting a cause of a fault of an electric power converting device equipped with a semiconductor element and its peripheral system and, as a result hereof, have obtained knowledge described below.

The technical approach according to Patent Literature 1 is considered to offer a great benefit for pre-empting breakdown of a semiconductor element, since this approach copes with multiple short circuit modes that are foreseen and decreases the probability of false detection as much as possible.

However, no consideration is made about identifying a cause leading to activation of a protection function in Patent Literature 1. Activation of a protection function is likely to be triggered by a cause of a fault persistently inhering in an intended electric power converting device and its peripheral system. One of means for picking out such a cause of a fault is, inter alia, analyzing signals that are acquired from a semiconductor element.

In addition, to analysis the signals, it is required that the intended device is provided with a transmission means for transmitting the signals and a recording unit that records the signals. The more the sorts of signals to be recorded, the signals will be the more helpful for analysis. But, in a case where a transmission cable is used as a transmission means, the number of cables increases in proportion to an increase in the number of sorts of signals and there is an disadvantage of running up the operating cost of wiring the cables as well as the cost of transmission cables themselves. In addition to this, there is also a possible situation where multiple transmission cables themselves are hard to wire because of structural constraints of the intended device.

An object of the present invention relates to detecting and recording a state of a semiconductor element in order to pick out a cause of a fault of an electric power converting device equipped with a semiconductor element and its peripheral system.

### Solution to Problem

Accordingly, there is provided an electric power converting device and a method of recording a state of an electric power converting device according to the independent claims. The present invention relates to an electric power converting device including plural detection units to detect a state of a semiconductor element, a transmitter to transmit a signal generated by the detection units, a receiver to receive a signal transmitted from the transmitter, and a memory to record a signal generated by the receiver, and recording a state of the semiconductor element while the electric power converting device is operating. Preferably, a signal that is transmitted from the transmitter to the receiver is transmitted by a single transmission cable.

### Advantageous Effects of Invention

According to the present invention, by acquiring and recording plural signals regarding a semiconductor element, it would become easy to pick out a cause of a fault of an electric power converting device and its peripheral system and it is possible to enhance reliability. Additionally, transmitting a detected signal by a single transmission cable also makes it possible to reduce the transmission cable cost and wiring work cost.

### Brief Description of Drawings

Fig. 1 depicts a basic configuration of an electric power converting device pertaining to a first embodiment.
Fig. 2 depicts a gate signal detection unit in the electric power converting device pertaining to the first embodiment.
Fig. 3 depicts a gate signal waveform in the electric power converting device pertaining to the first embodiment.
Fig. 4 depicts an overcurrent signal detection unit in the electric power converting device pertaining to the first embodiment.
Fig. 5 depicts an overcurrent signal waveform in the electric power converting device pertaining to the first embodiment.
Fig. 6 depicts an overvoltage signal detection unit in the electric power converting device pertaining to the first embodiment.
Fig. 7 depicts an overvoltage signal waveform in the electric power converting device pertaining to the first embodiment.
Fig. 8 depicts a transmitter in the electric power converting device pertaining to the first embodiment.
Fig. 9 presents a waveform depiction regarding the transmitter in the electric power converting device pertaining to the first embodiment.
Fig. 10 depicts a receiver in the electric power converting device pertaining to the first embodiment.
Fig. 11 depicts a basic configuration of an electric power converting device pertaining to a second embodiment.
Fig. 12 depicts a basic configuration of an electric power converting device pertaining to a third embodiment.

### Description of Embodiments

An embodiment discloses an electric power converting device equipped with a semiconductor element that switches between conduction and cutting off of a main current, the electric power converting device including plural detection units to detect a state of the semiconductor element, a transmitter to transmit a signal generated by the detection units, a receiver to receive a signal transmitted from the transmitter, and a memory to record a signal generated by the receiver, and discloses that a state of the semiconductor element is recorded while the electric power converting device is operating.

Also, an embodiment discloses a method of recording a state of an electric power converting device for an electric power converting device equipped with a semiconductor element that switches between conduction and cutting off of a main current, the method for recording a state of the semiconductor element while the electric power converting device is operating, and discloses detecting a state of the semiconductor element by plural detection units, transmitting a signal generated by the detection devices by a transmitter, receiving a signal transmitted from the transmitter by a receiver, and recording, by a memory, a signal generated by the receiver.

Also, an embodiment discloses that a signal that is transmitted from the transmitter to the receiver is transmitted by a single transmission cable.

Also, an embodiment discloses that a signal that is transmitted from the transmitter to the receiver is converted to a single signal.

Also, an embodiment discloses that the memory records at least a gate signal, an overcurrent signal, or an overvoltage signal.

Also, an embodiment discloses that a gate signal detection unit acquires a gate-to-emitter voltage of the semiconductor element, compares that voltage with a gate voltage threshold value, and generates a gate signal that will be an on-level signal when the former is higher and an off-level signal when the former is lower.

Also, an embodiment discloses that an overcurrent signal detection unit acquires a voltage which is applied to an emitter parasitic inductance of the semiconductor element, calculates an integral value of the voltage by an integration circuit, compares the integral value with a conversion voltage corresponding to an overcurrent threshold value, and generates an overcurrent signal that will be an on-level signal when the former is larger and an off-level signal when the former is smaller.

Also, an embodiment discloses that an overvoltage signal detection unit acquires a voltage which is applied between a collector terminal and a gate terminal of the semiconductor element, compares that voltage with a breakdown voltage of a first zener diode provided in the detection unit, and generates an overvoltage signal that will be an on-level signal when the former is larger and an off-level signal when the former is smaller.

Also, an embodiment discloses that the overvoltage signal detection unit limits the voltage which is applied between the collector terminal and the gate terminal of the semiconductor element to below a voltage that is the sum of the breakdown voltages of the first zener diode and a second zener diode.

Also, an embodiment discloses that the transmitter acquires plural signals, assigns each of the signals to each bit of a binary signal, converts the binary signal to a multivalued decimal signal by a D-A converter, and outputs the multivalued decimal signal.

Also, an embodiment discloses that the receiver acquires a multivalued signal in decimal notation, converts the decimal signal to a binary signal by an A-D converter, and generates and outputs plural signals wherein 1 represents ON and 0 represents OFF in each bit.

In the following, the above and other features and advantageous effects of the present invention will be described with reference to the drawings. Now, the drawings are used solely for understanding of the invention and are not intended to limit the scope of rights.

### First Embodiment

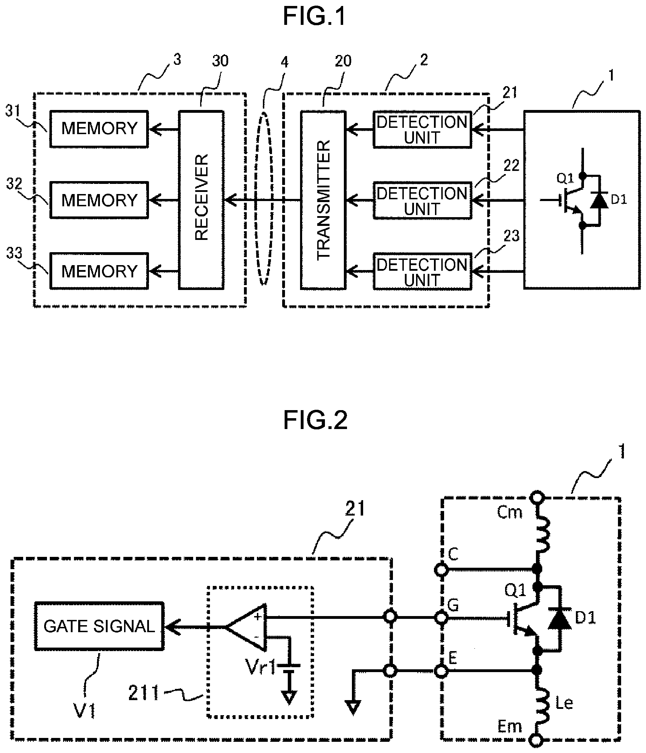

Fig. 1 depicts a basic configuration of an electric power converting device pertaining to the present embodiment. The electric power converting device pertaining to the present embodiment is comprised of a semiconductor module 1, a gate drive unit 2, and a control logic unit 3. The semiconductor module 1 is comprised of a semiconductor element Q1 and a rectification element D1 connected in inversely parallel with the element Q1. The semiconductor element Q1 performs a switching operation when a predetermined voltage is applied to its gate. This can switch between conduction and cutting off of a main current flowing in the semiconductor element Q1. On the other hand, the rectification element D1 is provided for the purpose of circulating the main current between the semiconductor element and a load while the current to the semiconductor element Q1 is cut off.

When the semiconductor module is placed in an operating state, occasionally, an overvoltage or an overcurrent exceeding rated voltage or current may take place contingently. As for an overvoltage, it often leads to breakdown of the semiconductor module at the same time as is occurrence and, therefore, it is effective to provide a protection function that limits voltage to below a certain voltage value. On the other hand, as for an overcurrent, it is possible to limit current to below a certain current value for a given period, since the semiconductor element Q1 is provided with a short circuit withstanding capacity; a protection function that cuts off current within this given period is desired.

In order to activate the production function, it is needed to acquire any signal indicating a state of the semiconductor module 1. Triggered by a state signal acquired by the gate drive unit 2, a contrivance that adjusts current flowing into a gate of the semiconductor module 1 to slow down the speed of cutting off current to the semiconductor element Q1 is, inter alia, one example of the production function.

While providing the protection functions, it is useful to detect a state of the semiconductor module 1 by a signal and analyze this signal for picking out a cause of a fault inhering in an intended electric power converting device and its peripheral system. Here, it is desired to record a signal acquired by the gate drive unit 2 in the control logic unit 3.

The gate drive unit 2 of the present embodiment has plural detection units and each unit detects a voltage or current by any means. Functions of these detection units are generating a signal to be recorded in the control logic unit 3 and generating a signal triggering each of the protection functions. The former signal passes through a transmitter 20 and a receiver 30 provided on the control logic unit 3 and recorded into each of plural memories also provided in the control logic unit 3.

In the present embodiment, plural signals which are transmitted from the transmitter 20 to the receiver 30 are converted into a single signal which is, in turn, transmitted by one transmission cable 4.

Signals which are recorded in the control logic unit 3 are a gate signal V1, an overcurrent signal V2, and an overvoltage signal V3. The gate drive unit 2 is comprised of a gate signal detection unit 21, an overcurrent signal detection unit 22, an overvoltage signal detection unit 23, and the transmitter 20. The control logic unit 3 is comprised of the receiver 30, a memory 31 for the gate signal, a memory 32 for the overcurrent signal, and a memory 33 for the overvoltage signal.

Fig. 2 depicts the gate signal detection unit in the electric power converting device pertaining to the present embodiment. The module 1 is provided with a gate terminal G, a collector terminal C, an emitter terminal E, a collector main terminal Cm, and an emitter main terminal Em. And, in the gate signal detection unit 21, the gate terminal G of the semiconductor module 1 is connected to a gate decision circuit 211 and the emitter terminal E is connected to a ground within the gate signal detection unit 21. The gate decision circuit 211 is comprised of an operational amplifier and a power supply and the voltage of the power supply which is connected to a minus terminal of the operational amplifier equals to a gate voltage threshold value Vr1.

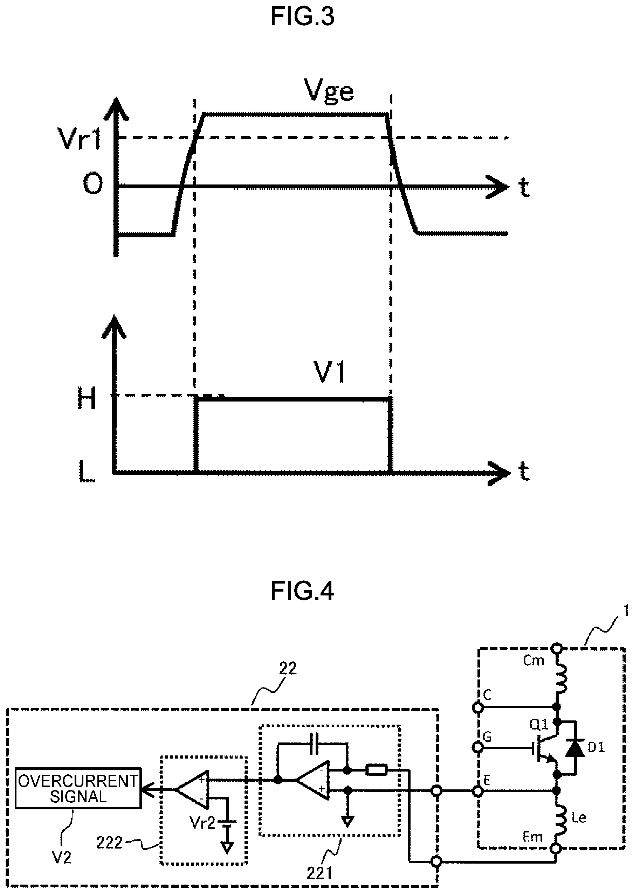

Fig. 3 depicts a gate signal waveform in the electric power converting device pertaining to the first embodiment. Fig. 3 illustrates a principle that the gate decision circuit 211 generates a gate signal V1. Given that Vge stands for a voltage which is applied between the gate terminal G and the emitter terminal E of the semiconductor module 1, the gate decision circuit operates so that the gate signal V1 will be H while the voltage Vge is higher than the gate voltage threshold value Vr1 and will be L while the voltage Vge is lower than Vr1. Here, a value of the gate voltage threshold value Vr1 must be determined, taking account of a voltage at which the semiconductor module actually turns on/off.

The gate signal V1 indicates the gate in the semiconductor module 1 is placed in which of the on and off states and is a state signal that is basic for analysis to pick out a cause of a fault. For instance, if it is detected that the gate signal V1 is on at timing that the signal should be off by right, a short circuit is suspected to occur.

Then, Fig. 4 depicts the overcurrent signal detection unit in the electric power converting device pertaining to the present embodiment. In the overcurrent signal detection unit 22, the emitter terminal E and the emitter main terminal Em of the semiconductor module 1 are connected to an integration circuit 221. The integration circuit 221 is comprised of an operational amplifier, a resistor, and a capacitor and it integrates a voltage which is applied to an emitter parasitic inductance Le and outputs a voltage Vc to which a collector current is converted by Vc = αIc. Here, α is a proportional constant that is determined from the emitter parasitic inductance Le and resistance and capacitance values of the resistor and the capacitor provided in the integration circuit 221.

The conversion voltage Vc resulting from the above conversion is input to an overcurrent decision circuit 222. The overcurrent decision circuit 222 is comprised of an operational amplifier and a power supply and the voltage of the power supply which is connected to a minus terminal of the operational amplifier equals to Vr2.

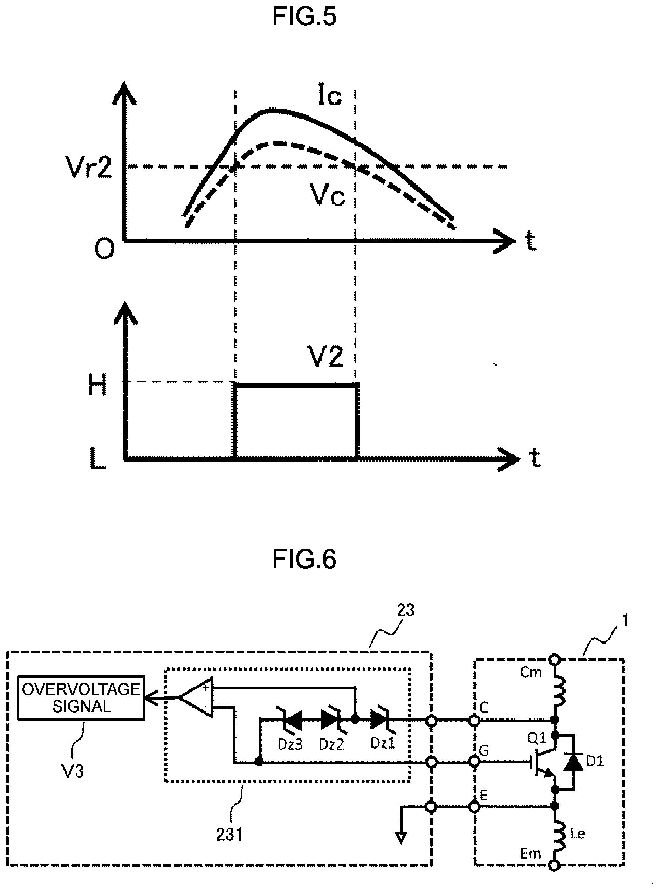

Fig. 5 depicts an overcurrent signal waveform in the electric power converting device pertaining to the present embodiment. Fig. 5 illustrates a principle that the overcurrent decision circuit 222 generates an overcurrent signal V2. The overcurrent decision circuit operates so that the overcurrent signal V2 will be H while the conversion voltage Vc is higher than Vr2 and will be L while the conversion voltage Vc is lower than Vr2. Here, Vr2 should be a value obtained by multiplying an overcurrent threshold value by the foregoing proportional constant α.

The overcurrent signal V2 signifies that the collector current Ic of the semiconductor module 1 has exceeded the overcurrent threshold value. In the event of a short circuit state, the semiconductor element Q1 behaves to make the current less than a limit value for a given period and, therefore, for detection of this, the overcurrent threshold value must be set smaller than the limit value.

Fig. 6 depicts the overvoltage signal detection unit in the electric power converting device pertaining to the present embodiment. In the overvoltage signal detection unit 23, the collector terminal C and the gate terminal G of the semiconductor module 1 are connected to an overvoltage decision circuit 231 and the emitter terminal E is connected to a ground within the overvoltage signal detection unit 23. The overvoltage decision circuit 231 is comprised of an operational amplifier and zener diodes Dz1 to Dz3.

A zener diode Dz1 whose breakdown voltage will be equal to an overvoltage threshold value Vr3 is selected. Exactly, the sum of its breakdown voltage and its gate voltage Vge should be equal to the overvoltage threshold value Vr3; however, the gate voltage Vge is negligible small, as compared with the breakdown voltage, and, therefore, ignored here. A zener diode Dz2 having a breakdown voltage of several V to several tens of V is used not to exceed a rated input voltage of the operational amplifier. A zener diode Dz3 is provided so that the collector terminal C and the gate terminal G will not be short-circuited when an inverse voltage is applied and a diode may be used instead.

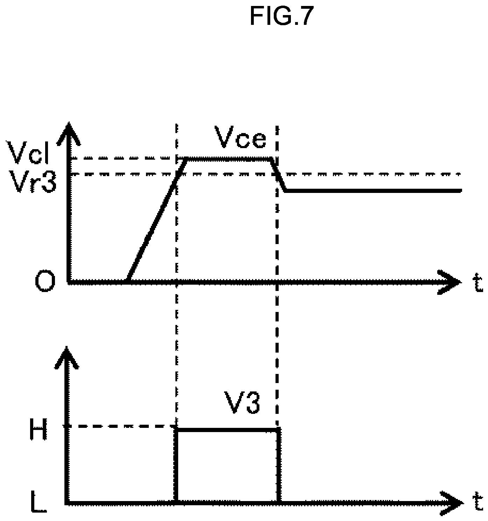

Fig. 7 depicts an overvoltage signal waveform in the electric power converting device pertaining to the present embodiment. Fig. 7 illustrates a principle that the overvoltage decision circuit 231 generates an overvoltage signal V3. An overvoltage occurs mostly at timing when the semiconductor element Q1 turns on and the waveform in Fig. 7 is that at the turn-on time. As illustrated in Fig. 7, the overvoltage decision circuit 231 operates so that the overvoltage signal V3 will be H while a collector-to-emitter voltage Vce is higher than the overvoltage threshold value Vr3 and will be L while Vce is lower than Vr3.

In addition, the collector-to-emitter voltage Vce is always limited to below a clamp voltage Vc1. The clamp voltage Vc1 is determined by the sum of the breakdown voltages of the zener diodes Dz1, Dz2. Upon breakdown of the zener diodes Dz1, Dz2, a breakdown current passes across the overvoltage decision circuit 231 and flows into the gate of the semiconductor element Q1 and this makes a gradual change of current at turn-off time. In consequence, because loss at turn-off time augments, it is need to check if the device is free from a problem in terms of thermal design, when the overvoltage decision circuit 231 is applied.

The overvoltage signal V3 signifies that the collector-to-emitter voltage Vce of the semiconductor module 1 has exceeded the overvoltage threshold value Vr3. At the same time, it can provide protection not to exceed the clamp voltage Vc1, even if an overvoltage has occurred.

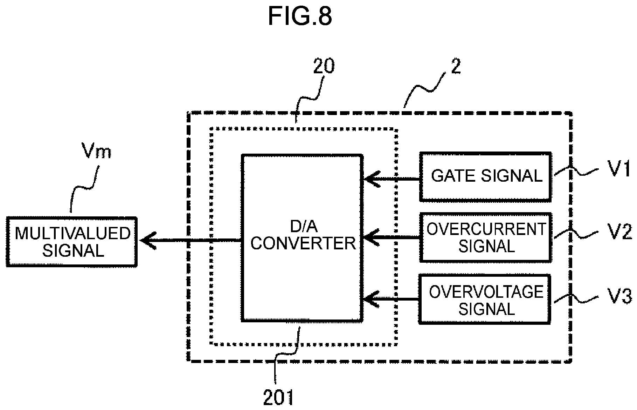

Fig. 8 depicts the transmitter in the electric power converting device pertaining to the present embodiment. The transmitter 20 is provided with a D-A converter 201 which takes inputs of the gate signal V1, overcurrent signal V2, and overvoltage signal V3 which are generated by the detection units 21 to 23 and outputs a single multivalued signal Vm. The D-A converter 201 (D/A converter) is capable of converting a binary signal in which the gate signal V1, overcurrent signal V2, and overvoltage signal V3 can be assigned to the first, second, third bits, respectively, to a decimal signal.

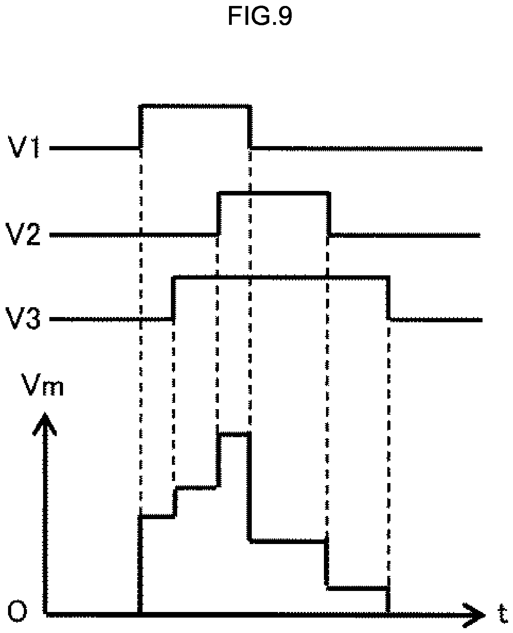

Fig. 9 presents a waveform depiction regarding the transmitter in the electric power converting device pertaining to the present embodiment. Fig. 9 illustrates one example of a relation between inputs (gate signal V1, overcurrent signal V2, and over voltage signal V3) and an output (multivalued signal Vm).

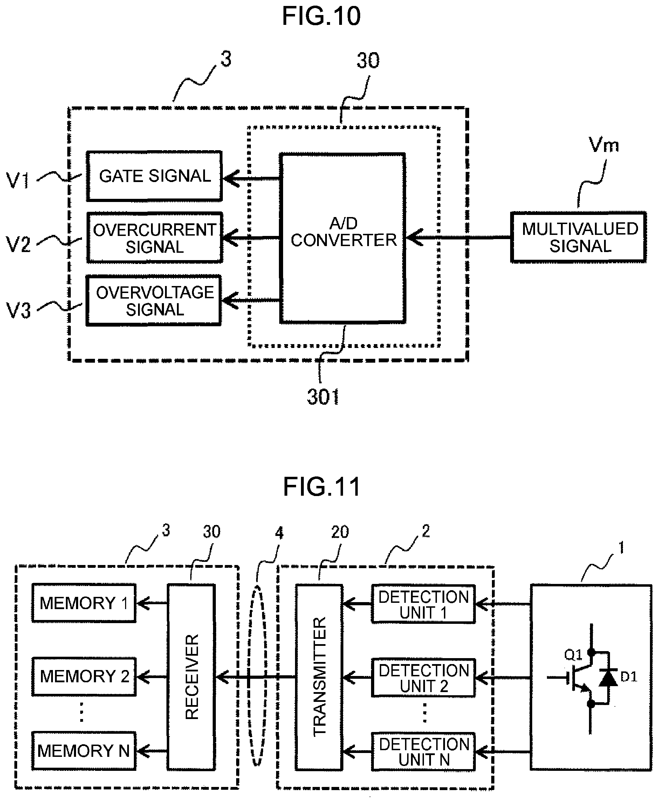

Fig. 10 depicts the receiver in the electric power converting device pertaining to the present embodiment. The receiver 30 is provided with an A-D converter 301 which takes input of the multivalued signal Vm generated at the transmitter 20 and outputs the gate signal V1, overcurrent signal V2, and overvoltage signal V3. The A-D converter (A/D converter) 301 converts the multivalued signal Vm in decimal notation to a binary signal, assigns the gate signal V1, overcurrent signal V2, and overvoltage signal V3 to the first, second, and third bits, respectively, and outputs these signals. A relation between the input multivalued signal Vm and the output gate signal V1, overcurrent signal V2, and overvoltage signal V3 is reverse to that with regard to the transmitter 20.

The gate signal V1, overcurrent signal V2, and overvoltage signal V3 thus transmitted are recorded into the memories 31 to 33 of the control logic unit 3. Thereby, it is enabled to monitor these signals while the device is operating and retrieve and analyze these recorded signals. As a result, it would become easy to pick out a cause of a fault of the electric power converting device and its peripheral system and it is possible to enhance reliability.

In addition, one transmission cable is only required to transmit three sorts of signals mentioned above between the gate drive unit 2 and the control logic unit 3 and there is no need to install plural cables. Generally, a transmission cable which is several tens of meters long is often used between the gate drive unit 2 and the control logic unit 3 and there is a great benefit of reducing the cable cost and wiring work cost.

### Second Embodiment

In the present embodiment, a case where N sorts of signals are transmitted is described. The following describes the present embodiment, focusing on difference from the first embodiment.

Fig. 11 depicts a basic configuration of an electric power converting device pertaining to the present embodiment. In the present embodiment, the gate drive unit 2 is provided with N pieces of detectors (detector 1, detector 2, ... detector N). The N pieces of detectors detect N pieces of signals indicating a state of the module 1, not limited to the gate signal V1, overcurrent signal V2, and overvoltage signal V3. Also, the control logic unit 3 is provided with N pieces of memories (memory 1, memory 2, ... memory N). N pieces of signals detected by the N pieces of detectors pass through the transmitter 20 and the transmission cable 4 and are transmitted to the receiver 30 and, then, recorded into the N pieces of memories, respectively.

According to the present embodiment, it is possible to detect and record a state of the module 1 in greater detail.

### Third Embodiment

In the present embodiment, a case where transmission is performed using plural transmission cables is described. The following describes the present embodiment, focusing on difference from the first and embodiments.

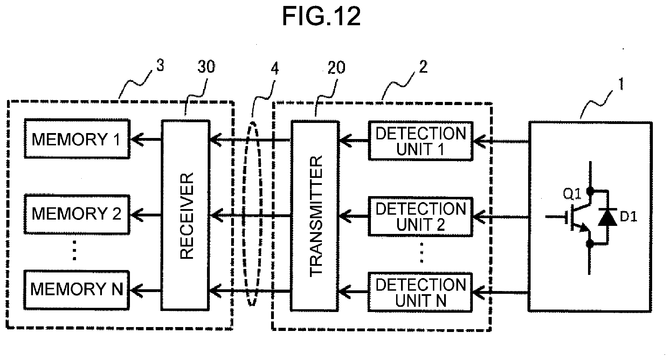

Fig. 12 depicts a basic configuration of an electric power converting device pertaining to the present embodiment. In the present embodiment, the gate drive unit 2 and the control logic unit 3 are liked with N pieces of transmission cables 4. N pieces of signals detected by N pieces of detectors are transmitted in parallel and recorded into N pieces of memories, respectively.

According to the present embodiment, signals detected by the detectors can be recorded without being subjected to conversion processing.

### List of Reference Signs

- 1: Semiconductor module
- 2: Gate drive unit
- 3: Control logic unit
- 4: Transmission cable
- 20: Transmitter
- 21: Gate signal detection unit
- 22: Overcurrent signal detection unit
- 23: Overvoltage signal detection unit
- 30: Receiver
- 31: Memory for gate signal
- 32: Memory for overcurrent signal
- 33: Memory for overvoltage signal
- 211: Gate decision circuit
- 231: Overvoltage decision circuit
- 201: D-A converter
- 301: A-D converter

## Claims

1. An electric power converting device equipped with a semiconductor element (Q1) that switches between conduction and cutting off of a main current, the electric power converting device comprising:
a plurality of detection units (21,22,23) to detect a state of the semiconductor element;
a transmitter (20) to transmit a signal generated by the plurality of detection units;
a receiver (30) to receive the signal transmitted from the transmitter; and
a memory (31,32,33) to record a signal generated by the receiver,
wherein a state of the semiconductor element is recorded while the electric power converting device is operating,
**characterised in that** the signal that is transmitted from the transmitter to the receiver is converted to a single signal and is transmitted by a single transmission cable (4).

2. The electric power converting device according to claim 1,
wherein the memory records at least a gate signal, an overcurrent signal, or an overvoltage signal.

3. The electric power converting device according to claim 4,
wherein the plurality of detectors include a gate signal detection unit (21) that acquires a gate-to-emitter voltage of the semiconductor element, compares that voltage with a gate voltage threshold value, and generates a gate signal that will be an on-level signal when the former is higher and an off-level signal when the former is lower.

4. The electric power converting device according to claim 4,
wherein the plurality of detectors include an overcurrent signal detection unit (22) that acquires a voltage which is applied to an emitter parasitic inductance of the semiconductor element, calculates an integral value of the voltage by an integration circuit, compares the integral value with a conversion voltage corresponding to an overcurrent threshold value, and generates an overcurrent signal that will be an on-level signal when the former is larger and an off-level signal when the former is smaller.

5. The electric power converting device according to claim 4,
wherein the plurality of detectors include an overvoltage signal detection unit (23) that acquires a voltage which is applied between a collector terminal and a gate terminal of the semiconductor element, compares that voltage with a breakdown voltage of a first zener diode provided in the detection unit, and generates an overvoltage signal that will be an on-level signal when the former is larger and an off-level signal when the former is smaller.

6. The electric power converting device according to claim 5,
wherein the overvoltage signal detection unit limits the voltage which is applied between the collector terminal and the gate terminal of the semiconductor element to below a voltage that is the sum of the breakdown voltages of the first zener diode and a second zener diode.

7. The electric power converting device according to claim 1,
wherein the transmitter acquires a plurality of signals, assigns each of the signals to each bit of a binary signal, converts the binary signal to a multivalued decimal signal by a D-A converter (201), and outputs the multivalued decimal signal.

8. The electric power converting device according to claim 1,
wherein the receiver acquires a multivalued signal in decimal notation, converts the decimal signal to a binary signal by an A-D converter (301), and generates and outputs a plurality of signals wherein 1 represents ON and 0 represents OFF in each bit.

9. A method of recording a state of an electric power converting device for an electric power converting device equipped with a semiconductor element (Q1) that switches between conduction and cutting off of a main current, the method for recording a state of the semiconductor element while the electric power converting device is operating, the method comprising:
detecting a state of the semiconductor element by a plurality of detection units (21,22,23);
transmitting a signal generated by the plurality of detection devices by a transmitter (20);
receiving the signal transmitted from the transmitter by a receiver (30); and
recording, by a memory (31,32,33), a signal generated by the receiver, **characterised in that** the method further comprises transmitting the signal from the transmitter to the receiver by a single transmission cable (4),
wherein the signal that is transmitted from the transmitter to the receiver is converted to a single signal.

10. The method of recording a state of an electric power converting device according to claim 9, comprising recording at least a gate signal, an overcurrent signal, or an overvoltage signal.

11. The method of recording a state of an electric power converting device according to claim 10, comprising acquiring a gate-to-emitter voltage of the semiconductor element, comparing that voltage with a gate voltage threshold value, and generating a gate signal that will be an on-level signal when the former is higher and an off-level signal when the former is lower.

12. The method of recording a state of an electric power converting device according to claim 10, comprising acquiring a voltage which is applied to an emitter parasitic inductance of the semiconductor element, calculating an integral value of the voltage by an integration circuit, comparing the integral value with a conversion voltage corresponding to an overcurrent threshold value, and generating an overcurrent signal that will be an on-level signal when the former is larger and an off-level signal when the former is smaller.

13. The method of recording a state of an electric power converting device according to claim 10, comprising acquiring a voltage which is applied between a collector terminal and a gate terminal of the semiconductor element, comparing that voltage with a breakdown voltage of a first zener diode provided in a detection unit, and generating an overvoltage signal that will be an on-level signal when the former is larger and an off-level signal when the former is smaller.

14. The method of recording a state of an electric power converting device according to claim 13, comprising limiting the voltage which is applied between the collector terminal and the gate terminal of the semiconductor element to below a voltage that is the sum of the breakdown voltages of the first zener diode and a second zener diode.

15. The method of recording a state of an electric power converting device according to claim 9, comprising, at the transmitter, acquiring a plurality of signals, assigning each of the signals to each bit of a binary signal, converting the binary signal to a multivalued decimal signal by a D-A converter (201), and outputting the multivalued decimal signal.

16. The method of recording a state of an electric power converting device according to claim 9, comprising, at the receiver, acquiring a multivalued signal in decimal notation, converting the decimal signal to a binary signal by an A-D converter (301), and generating and outputting a plurality of signals wherein 1 represents ON and 0 represents OFF in each bit.

## Patentansprüche

1. Vorrichtung zur Umwandlung von elektrischer Leistung, die mit einem Halbleiterelement (Q1) ausgestattet ist, das zwischen Leiten und Unterbrechen eines Hauptstroms umschaltet, wobei die Vorrichtung zur Umwandlung von elektrischer Leistung Folgendes umfasst:
eine Vielzahl von Detektionseinheiten (21, 22, 23) zum Detektieren eines Zustands des Halbleiterelements;
einen Sender (20) zum Senden eines von der Vielzahl von Detektionseinheiten erzeugten Signals;
einen Empfänger (30) zum Empfangen des vom Sender gesendeten Signals; und
einen Speicher (31, 32, 33) zum Aufzeichnen eines vom Empfänger erzeugten Signals,
wobei ein Zustand des Halbleiterelements aufgezeichnet wird, während die Vorrichtung zur Umwandlung von elektrischer Leistung in Betrieb ist,
**dadurch gekennzeichnet, dass** das Signal, das vom Sender an den Empfänger gesendet wird in ein einzelnes Signal umgewandelt und über ein einzelnes Übertragungskabel (4) gesendet wird.

2. Vorrichtung zur Umwandlung von elektrischer Leistung nach Anspruch 1,
wobei der Speicher zumindest ein Gate-Signal, ein Überstromsignal oder ein Überspannungssignal aufzeichnet.

3. Vorrichtung zur Umwandlung von elektrischer Leistung nach Anspruch 4,
wobei die Vielzahl von Detektoren eine Gate-Signal-Detektionseinheit (21) umfasst, die eine Gate-Emitter-Spannung des Halbleiterelements erfasst, diese Spannung mit einem Gate-Spannungsschwellwert vergleicht und ein Gate-Signal erzeugt, das ein EIN-Pegel-Signal ist, wenn die erstere höher ist, und ein AUS-Pegel-Signal ist, wenn die erstere niedriger ist.

4. Vorrichtung zur Umwandlung von elektrischer Leistung nach Anspruch 4,
wobei die Vielzahl von Detektoren eine Überstromsignaldetektionseinheit (22) umfasst, die eine Spannung erfasst, die an eine Emitter-Parasitärinduktivität des Halbleiterelements angelegt wird, einen Integralwert der Spannung durch einen Integrationsschaltkreis berechnet, den Integralwert mit einer Umwandlungsspannung vergleicht, die einem Überstromschwellwert entspricht, und ein Überstromsignal erzeugt, das ein EIN-Pegel-Signal ist, wenn der erstere höher ist, und ein AUS-Pegel-Signal ist, wenn der erstere niedriger ist.

5. Vorrichtung zur Umwandlung von elektrischer Leistung nach Anspruch 4,
wobei die Vielzahl von Detektoren eine Überspannungssignaldetektionseinheit (23) umfasst, die eine Spannung erfasst, die zwischen einem Kollektoranschluss und einem Gate-Anschluss des Halbleiterelements angelegt wird, diese Spannung mit einer Durchbruchsspannung einer ersten Zener-Diode vergleicht, die in der Detektionseinheit bereitgestellt ist, und ein Überspannungssignal erzeugt, das ein EIN-Pegel-Signal ist, wenn die erstere größer ist, und ein AUS-Pegel-Signal ist, wenn die erstere kleiner ist.

6. Vorrichtung zur Umwandlung von elektrischer Leistung nach Anspruch 5,
wobei die Überspannungssignaldetektionseinheit die Spannung, die zwischen dem Kollektoranschluss und dem Gate-Anschluss des Halbleiterelements angelegt wird, auf unter eine Spannung begrenzt, welche die Summe der Durchbruchsspannungen der ersten Zener-Diode und einer zweiten Zener-Diode ist.

7. Vorrichtung zur Umwandlung von elektrischer Leistung nach Anspruch 1,
wobei der Sender eine Vielzahl von Signalen erfasst, jedes der Signale jeweils einem Bit eines binären Signals zuordnet, das binäre Signal mit einem D-A-Wandler (201) in ein mehrwertiges Dezimalsignal umwandelt und das mehrwertige Dezimalsignal ausgibt.

8. Vorrichtung zur Umwandlung von elektrischer Leistung nach Anspruch 1,
wobei der Empfänger ein mehrwertiges Signal in Dezimaldarstellung erfasst, das Dezimalsignal mit einem A-D-Wandler (301) in ein binäres Signal umwandelt und eine Vielzahl von Signalen erzeugt und ausgibt, wobei in jedem Bit 1 für EIN steht und 0 für AUS steht.

9. Verfahren zum Aufzeichnen eines Zustands einer Vorrichtung zur Umwandlung von elektrischer Leistung für eine Vorrichtung zur Umwandlung von elektrischer Leistung, die mit einem Halbleiterelement (Q1) ausgestattet ist, das zwischen Leiten und Unterbrechen eines Hauptstroms umschaltet, wobei das Verfahren zum Aufzeichnen eines Zustands des Halbleiterelements dient, während die Vorrichtung zur Umwandlung von elektrischer Leistung in Betrieb ist, wobei das Verfahren Folgendes umfasst:
Detektieren eines Zustands des Halbleiterelements durch eine Vielzahl von Detektionseinheiten (21, 22, 23);
Senden eines von der Vielzahl von Detektionseinheiten erzeugten Signals durch einen Sender (20);
Empfangen des vom Sender gesendeten Signals durch einen Empfänger (30); und
Aufzeichnen eines vom Empfänger erzeugten Signals durch einen Speicher (31, 32, 33), **dadurch gekennzeichnet, dass** das Verfahren außerdem das Senden des Signals vom Sender zum Empfänger über ein einzelnes Übertragungskabel (4) umfasst,
wobei das Signal, das vom Sender an den Empfänger gesendet wird in ein einzelnes Signal umgewandelt wird.

10. Verfahren zum Aufzeichnen eines Zustands einer Vorrichtung zur Umwandlung von elektrischer Leistung nach Anspruch 9, welches das Aufzeichnen zumindest eines Gate-Signals, eines Überstromsignals oder eines Überspannungssignals umfasst.

11. Verfahren zum Aufzeichnen eines Zustands einer Vorrichtung zur Umwandlung von elektrischer Leistung nach Anspruch 10, welches das Erfassen einer Gate-Emitter-Spannung des Halbleiterelements, das Vergleichen dieser Spannung mit einem Gatespannungsschwellwert und das Erzeugen eines Gate-Signals umfasst, das ein EIN-Pegel-Signal ist, wenn die erstere höher ist, und ein AUS-Pegel-Signal ist, wenn die erstere niedriger ist.

12. Verfahren zum Aufzeichnen eines Zustands einer Vorrichtung zur Umwandlung von elektrischer Leistung nach Anspruch 10, welches das Erfassen einer Spannung, die an eine Emitter-Parasitärinduktivität des Halbleiterelements angelegt wird, das Berechnen eines Integralwerts der Spannung durch einen Integrationsschaltkreis, das Vergleichen des Integralwerts mit einer Umwandlungsspannung, die einem Überstromschwellenwert entspricht, und das Erzeugen eines Überstromsignals umfasst, das ein EIN-Pegel-Signal ist, wenn der erstere höher ist, und ein AUS-Pegel-Signal ist, wenn der erstere niedriger ist.

13. Verfahren zum Aufzeichnen eines Zustands einer Vorrichtung zur Umwandlung von elektrischer Leistung nach Anspruch 10, welches das Erfassen einer Spannung, die zwischen einem Kollektoranschluss und einem Gate-Anschluss des Halbleiterelements angelegt wird, das Vergleichen dieser Spannung mit einer Durchbruchsspannung einer ersten Zener-Diode, die in der Detektionseinheit bereitgestellt ist, und das Erzeugen eines Überspannungssignals umfasst, das ein EIN-Pegel-Signal ist, wenn der erstere größer ist, und ein AUS-Pegel-Signal ist, wenn der erstere kleiner ist.

14. Verfahren zum Aufzeichnen eines Zustands einer Vorrichtung zur Umwandlung von elektrischer Leistung nach Anspruch 13, welches das Begrenzen der Spannung, die zwischen dem Kollektoranschluss und dem Gate-Anschluss des Halbleiterelements angelegt wird, auf unter eine Spannung umfasst, welche die Summe der Durchbruchsspannungen der ersten Zener-Diode und einer zweiten Zener-Diode ist.

15. Verfahren zum Aufzeichnen eines Zustands einer Vorrichtung zur Umwandlung von elektrischer Leistung nach Anspruch 9, welches das Erfassen einer Vielzahl von Signalen am Sender, das Zuordnen jedes der Signale jeweils einem Bit eines binären Signals, das Umwandeln des binären Signals in ein mehrwertiges Dezimalsignal mit einem D-A-Wandler (201) und das Ausgeben des mehrwertigen Dezimalsignals umfasst.

16. Verfahren zum Aufzeichnen eines Zustands einer Vorrichtung zur Umwandlung von elektrischer Leistung nach Anspruch 9, welches das Erfassen eines mehrwertigen Signals in Dezimaldarstellung am Empfänger, das Umwandeln des Dezimalsignals in ein binäres Signal mit einem A-D-Wandler (301) und das Erzeugen und Ausgeben einer Vielzahl von Signalen umfasst, wobei in jedem Bit 1 für EIN steht und 0 für AUS steht.

## Revendications

1. Dispositif de conversion d'énergie électrique équipé d'un élément semi-conducteur (Q1) qui commute entre la conduction et la coupure d'un courant principal, le dispositif de conversion d'énergie électrique comprenant :
une pluralité d'unités de détection (21, 22, 23) pour détecter un état de l'élément semi-conducteur ;
un transmetteur (20) pour transmettre un signal généré par la pluralité d'unités de détection ;
un récepteur (30) pour recevoir le signal transmis par le transmetteur ; et
une mémoire (31, 32, 33) pour enregistrer un signal généré par le récepteur,
dans lequel un état de l'élément semi-conducteur est enregistré pendant que le dispositif de conversion d'énergie électrique fonctionne,
**caractérisé en ce que**
le signal qui est transmis par le transmetteur au récepteur est convertie en un seul signal et est transmis par un seul câble de transmission (4).

2. Dispositif de conversion d'énergie électrique selon la revendication 1,
dans lequel la mémoire enregistre au moins un signal de grille, un signal de surintensité ou un signal de surtension.

3. Dispositif de conversion d'énergie électrique selon la revendication 4,
dans lequel la pluralité de détecteurs comprennent une unité de détection signal de grille (21) qui acquiert une tension grille-vers-émetteur de l'élément semi-conducteur, compare cette tension avec une valeur seuil tension de grille et génère un signal de grille qui sera un signal de niveau « marche » lorsque ce dernier est plus élevé et un signal de niveau « arrêt » lorsque ce dernier est plus faible.

4. Dispositif de conversion d'énergie électrique selon la revendication 4,
dans lequel la pluralité de détecteurs comprennent une unité de détection de signal de surintensité (22) qui acquiert une tension qui est appliquée à une inductance parasite d'émetteur de l'élément semi-conducteur, calcule une valeur intégrale de la tension à l'aide d'un circuit d'intégration, compare la valeur intégrale avec une tension de conversion correspondant à une valeur seuil de surintensité et génère un signal de surintensité qui sera un signal de niveau « marche » lorsque ce dernier est plus élevé et un signal de niveau « arrêt » lorsque ce dernier est plus faible.

5. Dispositif de conversion d'énergie électrique selon la revendication 4,
dans lequel la pluralité de détecteurs comprennent une unité de détection de signal de surtension (23) qui acquiert une tension qui est appliquée entre une borne de collecteur et une borne de grille de l'élément semi-conducteur, compare cette tension avec une tension de rupture d'une première diode zener disposée dans l'unité de détection et génère un signal de surtension qui sera un signal de niveau « marche » lorsque ce dernier est plus élevé et un signal de niveau « arrêt » lorsque ce dernier est plus faible.

6. Dispositif de conversion d'énergie électrique selon la revendication 5,
dans lequel l'unité de détection de signal de surtension limite la tension qui est appliquée entre la borne de collecteur et la borne de grille de l'élément semi-conducteur en dessous d'une tension qui est la somme des tensions de rupture de la première diode zener et d'une deuxième diode zener.

7. Dispositif de conversion d'énergie électrique selon la revendication 1,
dans lequel le transmetteur acquiert une pluralité de signaux, assigne chacun des signaux à chaque bit d'un signal binaire, convertit le signal binaire en un signal décimal multivaleur à l'aide d'un convertisseur digital-analogique (201) et sort le signal décimal multivaleur.

8. Dispositif de conversion d'énergie électrique selon la revendication 1,
dans lequel le récepteur acquiert un signal multivaleur en notation décimale, convertit le signal décimal en un signal binaire à l'aide d'un convertisseur analogique-digital (301) et génère et sort une pluralité de signaux dans lesquels 1 représente MARCHE et 0 représente ARRÊT dans chaque bit.

9. Procédé d'enregistrement d'un état d'un dispositif de conversion d'énergie électrique pour un dispositif de conversion d'énergie électrique équipé d'un élément semi-conducteur (Q1) qui commute entre la conduction et la coupure d'un courant principal, ce procédé étant conçu pour l'enregistrement d'un état de l'élément semi-conducteur pendant le fonctionnement du dispositif de conversion d'énergie électrique, ce procédé comprenant :
la détection d'un état de l'élément semi-conducteur à l'aide d'une pluralité d'unités de détection (21, 22, 23) ;
la transmission d'un signal généré par la pluralité de dispositifs de détection à l'aide d'un transmetteur (20) ;
la réception du signal transmis par le transmetteur à l'aide d'un récepteur 30 ; et
l'enregistrement, à l'aide d'une mémoire (31, 32, 33) d'un signal généré par le récepteur
**caractérisé en ce que** le procédé comprend en outre la transmission du signal du transmetteur au récepteur par un seul câble de transmission (4),
dans lequel le signal qui est transmis par le transmetteur au récepteur est converti en un seul signal.

10. Procédé d'enregistrement d'un état d'un dispositif de conversion d'énergie électrique selon la revendication 9, comprenant l'enregistrement d'au moins un signal de grille, d'un signal de surintensité ou d'un signal de surtension.

11. Procédé d'enregistrement d'un état d'un dispositif de conversion d'énergie électrique selon la revendication 10, comprenant l'acquisition d'une tension grille-vers-émetteur de l'élément semi-conducteur, la comparaison de cette tension avec une valeur seuil tension de grille et la génération d'un signal de grille qui sera un signal de niveau « marche » lorsque ce dernier est plus élevé et un signal de niveau « arrêt » lorsque ce dernier est plus faible.

12. Procédé d'enregistrement d'un état d'un dispositif de conversion d'énergie électrique selon la revendication 10, comprenant l'acquisition d'une tension qui est appliquée à une inductance parasite d'émetteur de l'élément semi-conducteur, le calcul d'une valeur intégrale de la tension à l'aide d'un circuit d'intégration, la comparaison de la valeur intégrale avec une tension de conversion correspondant à une valeur seuil de surintensité et la génération d'un signal de surintensité qui sera un signal de niveau « marche » lorsque ce dernier est plus élevé et un signal de niveau « arrêt » lorsque ce dernier est plus faible.

13. Procédé d'enregistrement d'un état d'un dispositif de conversion d'énergie électrique selon la revendication 10, comprenant l'acquisition d'une tension qui est appliquée entre une borne de collecteur et une borne de grille de l'élément semi-conducteur, la comparaison de cette tension avec une tension de rupture d'une première diode zener disposée dans l'unité de détection et la génération d'un signal de surtension qui sera un signal de niveau « marche » lorsque ce dernier est plus élevé et un signal de niveau « arrêt » lorsque ce dernier est plus faible.

14. Procédé d'enregistrement d'un état d'un dispositif de conversion d'énergie électrique selon la revendication 13, comprenant la limitation de la tension qui est appliquée entre une borne de collecteur et une borne de grille de l'élément semi-conducteur en dessous d'une tension qui est la somme des tensions de rupture de la première diode zener et d'une deuxième diode zener.

15. Procédé d'enregistrement d'un état d'un dispositif de conversion d'énergie électrique selon la revendication 9, comprenant, au niveau du transmetteur, l'acquisition d'une pluralité de signaux, l'assignation de chacun des signaux à chaque bit d'un signal binaire, la conversion du signal binaire en un signal décimal multivaleur à l'aide d'un convertisseur digital-analogique (201) et la sortie du signal décimal multivaleur.

16. Procédé d'enregistrement d'un état d'un dispositif de conversion d'énergie électrique selon la revendication 9, comprenant, au niveau du récepteur, l'acquisition d'un signal multivaleur en notation décimale, la conversion du signal décimal en un signal binaire à l'aide d'un convertisseur analogique-digital (301) et la génération et la sortie d'une pluralité de signaux dans lesquels 1 représente MARCHE et 0 représente ARRÊT dans chaque bit.
